# EUROPÄISCHE PATENTSCHRIFT

(11) **EP 0 726 639 B1**
(45) Veröffentlichungstag und Bekanntmachung des Hinweises auf die Patenterteilung: **08.09.1999**
(21) Anmeldenummer: 96101865.2
(22) Anmeldetag: 09.02.1996
(51) Int. Cl.: H02K 37/14, H02K 16/04

(54) **Schrittmotor**
Step motor
Moteur pas à pas

(30) Priorität: 11.02.1995 DE 19504387
(43) Veröffentlichungstag der Anmeldung: 14.08.1996
(73) Patentinhaber: TRW Automotive Electronics & Components GmbH & Co. KG, 78315 Radolfzell (DE)
(72) Erfinder: Sauter, Roland, D-78056 Villingen-Schwenningen (DE); Benz, Jörg, D-78078 Niedereschach (DE)
(74) Vertreter: Eder, Thomas, Dr.-Ing.

(56) Entgegenhaltungen:
- EP-A- 0 509 351
- GB-A- 2 230 652
- GB-A- 2 235 593
- US-A- 5 068 562
- US-A- 5 384 506

## Beschreibung

Die Erfindung betrifft einen Schrittmotor gemäß Oberbegriff des Anspruchs 1, wie er in GB-A-2 230 652 offenbart ist.

Derartige Schrittmotoren haben in den letzten Jahren, beispielsweise im Automobilbau, große Bedeutung erlangt und dienen zur analogen Darstellung von Fahrzuständen und Fahrerinformationen, wobei digitale Meßwerte, beispielsweise der Geschwindigkeit, der Motordrehzahl, des Kraftstoffvorrats, des Öldrucks, etc. hochauflösend zur Anzeige gebracht werden. Die Einzelschritte müssen hierbei so klein gewählt werden, daß der Betrachter diese nicht mehr als solche wahrnehmen kann, sondern den Eindruck einer kontinuierlichen Analoganzeige vermittelt bekommt. In der Regel ist es deshalb erforderlich, den Schrittmotor mit einem Reduziergetriebe zu versehen, der den Schrittwinkel des Rotors in einen stark reduzierten Winkelausschlag der Abtriebs- bzw. Anzeigewelle umsetzt. Üblicherweise werden Reduziergetriebe mit einem Untersetzungsverhältnis von 60 : 1 verwendet, die in Verbindung mit üblichen Schrittwinkeln eine ausreichende Auflösung erlauben.

In diesem Zusammenhang ist auch von besonderer Bedeutung, daß der Schrittmotor einfach und robust aufgebaut und damit kostengünstig zu fertigen ist. Ein solcher Schrittmotor ist beispielsweise aus der DE 42 07 978 bekanntgeworden, der zwei übereinander und zueinander winkelversetzt angeordnete Statoren besitzt. Die Statoren sind hierbei ringförmig ausgebildet und umfassen den mit einem Permanentmagneten versehenen Rotor jeweils vollständig in Umfangsrichtung. Der Zusammenbau des gesamten Schrittmotors gestaltet sich vergleichsweise einfach, da sämtliche Bauteile sukzessive in ein Gehäuse eingesetzt werden. Entsprechend aufeinander abgestimmte Positionierelemente sorgen dafür, daß sämtliche Bauteile ausschließlich in der vorgegebenen Zuordnung eingeführt werden können. Dies betrifft insbesondere auch die Statoren, die den vorgesehenen Winkelversatz aufweisen müssen.

Nachteilig hierbei ist der vergleichsweise hohe Aufwand, der an dem Gehäuse und den Statoren erforderlich ist, um die Positionierelemente anzuformen. Weiterhin gestaltet sich insbesondere der Aufbau der beiden Statoren vergleichsweise aufwendig, da wegen der Ringform der Spulen die Statorbleche speziell geformt sein müssen. Die koaxiale Anordnung der beiden ringförmigen Statoren führt außerdem zu einer relativ großen Bauhöhe des Schrittmotors, die für eine Reihe von Anwendungen unerwünscht ist. Auch treten bei dieser Art der Anordnung hohe Axialkräfte auf, die zu einer axialen Auslenkung des Rotors (sog. Springen) führen.

Der Erfindung lag deshalb das Problem zugrunde, einen Schrittmotor der eingangs genannten Art zur Verfügung zu stellen, der die geschilderten Nachteile nicht mehr aufweist. Insbesondere sollte ein einfach aufgebauter Schrittmotor realisiert werden, der eine besonders flache Bauweise ermöglicht.

Gelöst wird dieses Problem durch einen Schrittmotor, der die Merkmale des Anspruchs 1 aufweist.

Vorteilhafte Ausgestaltungen der Erfindung sind durch die Merkmale der Unteransprüche angegeben.

Die Erfindung basiert auf der Idee, die Statorbleche eben und in U-förmiger Grundgestalt auszubilden, so daß zwei parallel verlaufende Schenkel entstehen. Die sich gegenüberliegenden Schenkelenden bilden ein Polpaar und umfassen den Rotor längs zweier Umfangsabschnitte. Zur Realisierung eines möglichst kleinen Luftspalts zwischen den Polen und dem Rotor sind kreissegmentförmige Ausnehmungen an den Schenkeln vorgesehen.

Zwei solcher Statorbleche können beispielsweise um 90° zueinander winkelversetzt angeordnet werden, so daß sich im Bereich der übereinanderliegenden Schenkelenden eine Vier-Polanordnung ergibt. Die kreissegmentförmigen Ausnehmungen der Schenkelenden bilden (in Draufsicht) eine kreisrunde Öffnung, die der Rotor mit vergleichsweise geringem radialem Abstand durchsetzt.

Die ebene Ausgestaltung der Statorbleche erlaubt eine äußerst flache Bauweise des Schrittmotors. So können die beiden Statorbleche dicht übereinander angeordnet werden, wobei dieser Abstand geringer sein kann als die Dicke der Statorbleche selbst, die damit nicht mehr den limitierenden Faktor für eine möglichst geringe Bauhöhe des Schrittmotors darstellen. Weiterhin hat diese Art der Anordnung den Vorteil, daß die auftretenden Axialkräfte klein sind und das eingangs erläuterte Springen des Rotors praktisch ausgeschaltet ist.

Durch diese spezielle Ausgestaltung und Anordnung der Statorbleche besitzt der Schrittmotor einen ausgezeichneten Wirkungsgrad, d. h. er erzeugt ein hohes Drehmoment bei geringer Stromaufnahme. Durch die flache Bauweise ist auch die axiale Erstreckung des Rotors kleiner als bei herkömmlichen Schrittmotoren, so daß der Wirkungsgrad nochmals verbessert ist.

Die ebene Gestaltung erlaubt auch eine äußerst kostengünstige Fertigung der Statorbleche, beispielsweise in Form von einstückigen Stanzteilen, die keine weitere Bearbeitung mehr erfordern.

Die gewählte Konfiguration erlaubt es auch, beide Statorbleche deckungsgleich auszuführen und spiegelbildlich einzusetzen. Hierdurch ist lediglich ein einziger Statorblechtyp erforderlich.

Der Magnetfluß wird durch Spulen erzeugt, die vorteilhafterweise jeweils über einen der beiden Schenkel der Statorbleche geschoben und dort verrastet sind. Durch die U-Form der Statorbleche können die Spulen problemlos über das jeweilige Schenkelende geführt und bis in die Nähe des die beiden Schenkel verbindenden Stegs verschoben werden. Auch ist es möglich, für beide Statorbleche übereinstimmend gestaltete Spulen zu verwenden, so daß auch hier lediglich eine einzige Spulentype erforderlich ist.

Besondere Vorteile ergeben sich bei einem Rotor, bei dem zwei Polpaare um 180° winkelversetzt und koaxial beabstandet angeordnet sind. Der koaxiale Abstand entspricht dem Abstand der beiden Statorbleche, so daß jeweils ein Polpaar des Rotors exakt auf das korrespondierende, durch das Statorblech gebildete Polpaar ohne Höhenversatz ausgerichtet ist. Somit treten keine Axialkräfte mehr auf.

Vorteilhafterweise besitzt der Schrittmotor ein zweigeteiltes Gehäuse mit einem Gehäuseunterteil und einem darauf aufgesetzten Deckel, wobei das Gehäuseunterteil so gestaltet ist, daß sämtliche Bauteile, insbesondere die Statoren, der Rotor sowie das gegebenenfalls vorhandene Reduziergetriebe positionierend aufgenommen werden können. Es sind deshalb am Gehäuseunterteil Zapfen, Zapfenaufnahmen, Rastelemente und dergleichen angeformt, so daß beim Zusammensetzen des Schrittmotors die Bauteile einfach eingelegt und aufgesteckt werden können. Weiterhin ist von Vorteil, wenn der Deckel so gestaltet ist, daß nach dem Verrasten mit dem Gehäuseunterteil sämtliche Bauteile fixiert sind. Dies kann auf einfache Art und Weise dadurch erreicht werden, daß der Deckel zapfenartige Vorsprünge, Widerlager und Zapfenaufnahmen besitzt, so daß nach dem Verrasten mit dem Gehäuseunterteil sämtliche Bauteile fixiert und/oder beweglich gelagert sind. Dadurch kann der Schrittmotor ohne zusätzliche Fixiermittel, wie beispielsweise Schrauben oder Nieten, durch einfaches Ineinanderstecken äußerst kostengünstig gefertigt werden. Umgekehrt ergibt sich auch die Möglichkeit einer äußerst einfachen Demontage, um beispielsweise den Schrittmotor am Ende der Nutzungsdauer zu recyceln.

Die Erfindung wird näher anhand der in den Figuren dargestellten Ausführungsbeispielen erläutert. Es zeigen:
- Figur 1: Draufsicht des Schrittmotors mit abgehobenem Deckel,
- Figur 2: Schnitt A-A gemäß Figur 1, Gehäuseunterteil und Deckel im Schnitt, übrige Bauteile nicht geschnitten,
- Figur 3: Schnitt B-B gemäß Figur 1,
- Figur 4: Schnitt C-C gemäß Figur 1,
- Figur 5: gemeinsame Darstellung der Ansichten und Schnittdarstellungen gemäß Figur 1 bis 4 des Schrittmotors in einer geringfügig modifizierten Ausführungsvariante,
- Figur 5a: Detaildarstellung einer weiteren Ausführungsvariante und
- Figur 5b: Schnittdarstellung und Magnetisierungskurve des Rotors.

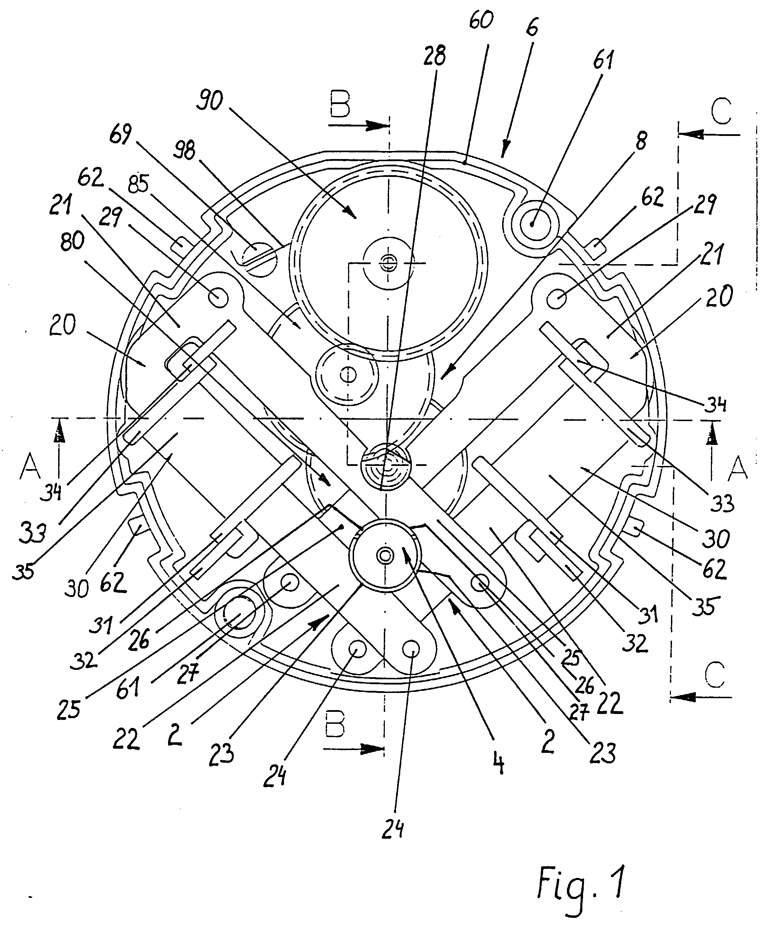

Zunächst wird die Erfindung anhand des in den Figuren 1 bis 4 dargestellten Schrittmotors erläutert. Es handelt sich hierbei um einen Zwei-Phasen-Schrittmotor in Vier-Polausführung, bei dem die Polpaare wechselpolig angeordnet sind.

Der Schrittmotor ist aus wenigen Hauptbaugruppen aufgebaut, nämlich zwei Statoren 2, einem Rotor 4 sowie einem Reduziergetriebe 8, die in einem Gehäuse 6, bestehend aus Gehäuseunterteil 60 und Deckel 70, untergebracht sind.

Der für die Erfindung charakteristische Aufbau der Statoren 2 und deren um 90° zueinander winkelversetzte Anordnung ergibt sich insbesondere aus der Darstellung gemäß Figur 1. Jeder der beiden Statoren 2 besitzt ein Statorblech 20, das eben und U-förmig gestaltet ist. Jedes der beiden Statorbleche 20 weist zwei im wesentlichen parallel verlaufende Schenkel 22, 25 auf, die über einen Steg 21 zu einem einstückig und durchgehenden U geformt sind. Im Endbereich der Schenkel 22, 25 sind kreissegmentförmige Ausnehmungen 23, 26 vorhanden, so daß der an dieser Stelle hindurchgeführte Rotor 4 konturangepaßt und längs zweier gegenüberliegender Umfangsabschnitte mit radialem Spiel umfaßt ist. Im Endbereich der Schenkel 22, 25 sind Befestigungslöcher 24, 27 vorhanden, die zusammen mit einem im Bereich des Stegs 21 vorgesehenen Befestigungsloch 29 eine Dreipunkt-Fixierung des Statorblechs 20 ermöglichen.

Der Schenkel 25 besitzt einen Freischnitt 28, um eine möglichst platzsparende Anordnung eines Übertragungsrades 80 des Reduziergetriebes 8 zu ermöglichen.

Über den Schenkel 22 ist eine Spule 30 geschoben und in hier nicht näher dargestellter Art und Weise verrastet. Die Spule 30 trägt eine Wicklung 35, die über Anschlußstifte 32, 34 von außen zugänglich und zwischen zwei Deckscheiben 31, 33 gehalten ist.

Beide Statorbleche 20 sind deckungsgleich ausgebildet und in bezug auf die Schnittlinie B-B gemäß Figur 1 spiegelsymmetrisch angeordnet. Der Winkel zwischen beiden Statorblechen 20 beträgt 90°, so daß im Bereich des Rotors 4 zwei Polpaare entstehen. Die Ausnehmungen 23, 26 stellen jeweils diese Polpaare dar, die in gleichmäßiger Winkelanordnung den Rotor 4 umgeben.

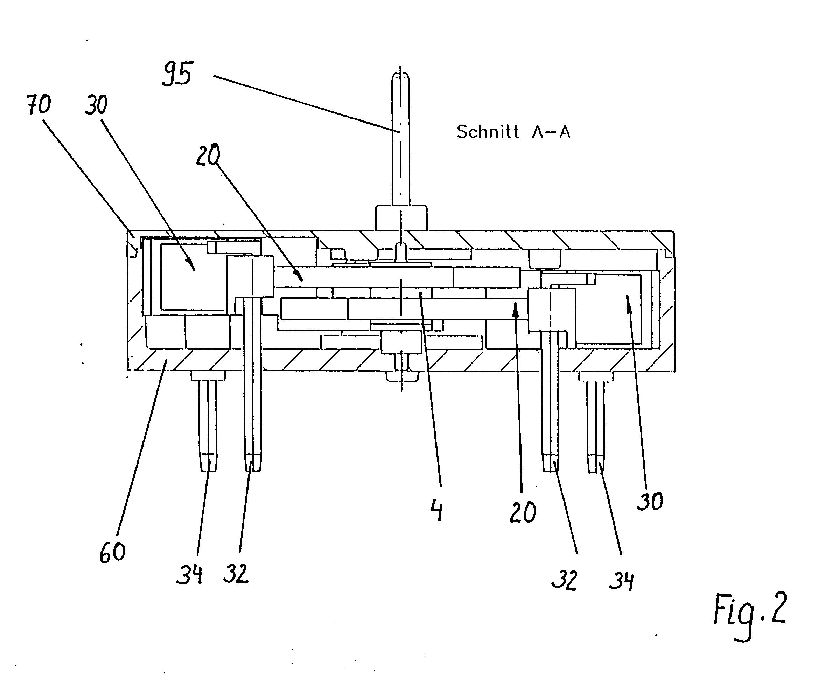

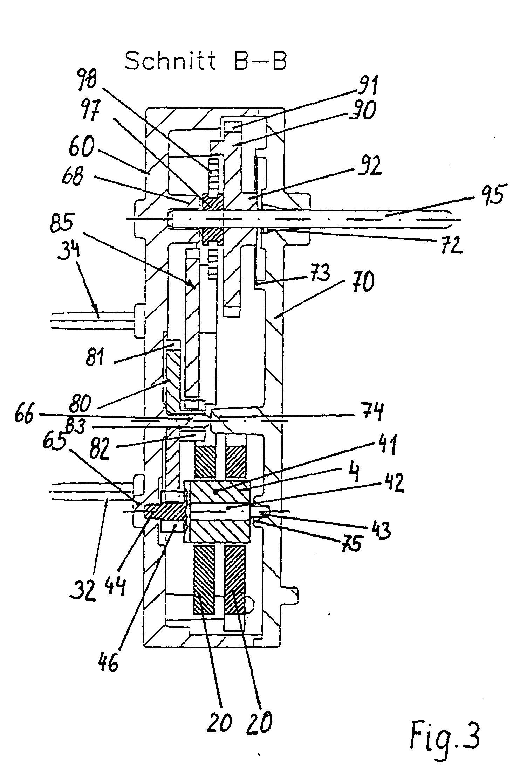

Die beiden Statorbleche 20 sind dicht übereinanderliegend angeordnet, wie sich beispielsweise aus den Figuren 2 oder 3 ergibt. Der (axiale) Abstand der beiden Statorbleche 20 beträgt lediglich einen Bruchteil der Dicke der Statorbleche 20, so daß der Schrittmotor insgesamt sehr flach baut. Der Abstand der beiden Statorbleche 20 ist so gewählt, daß eine Berührung der beiden Statorbleche 20 auch unter extremen Betriebsbedingungen zuverlässig vermieden ist, im übrigen jedoch möglichst gering ist.

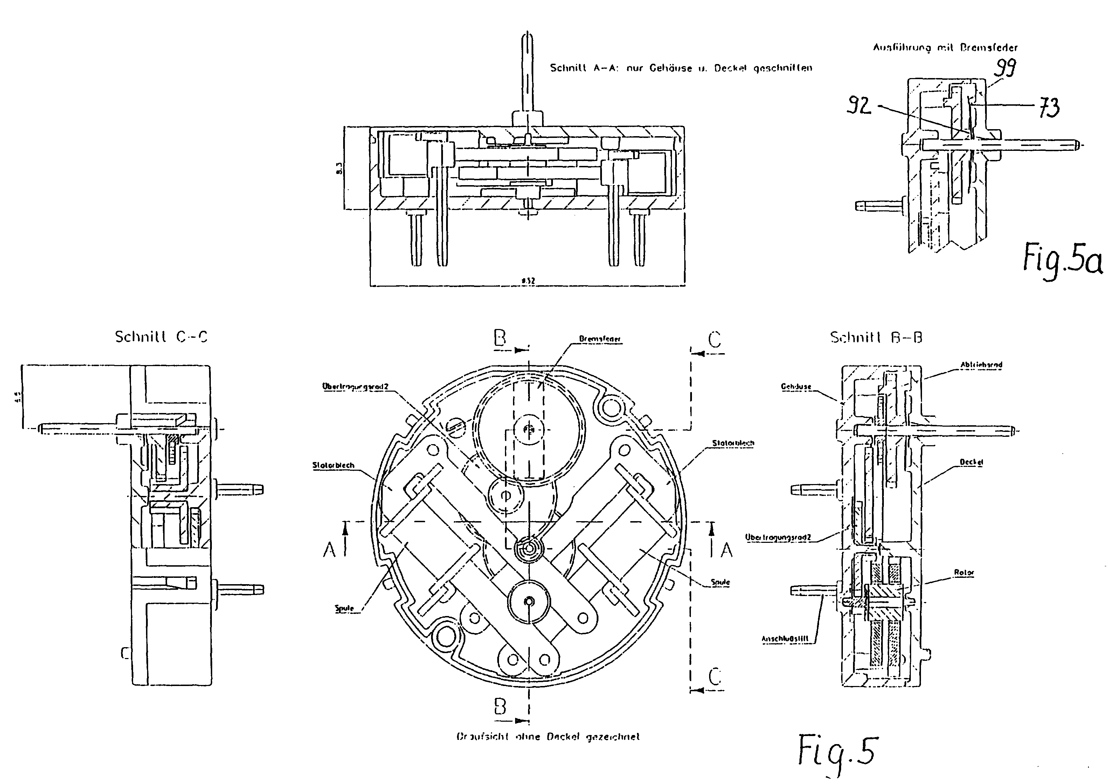

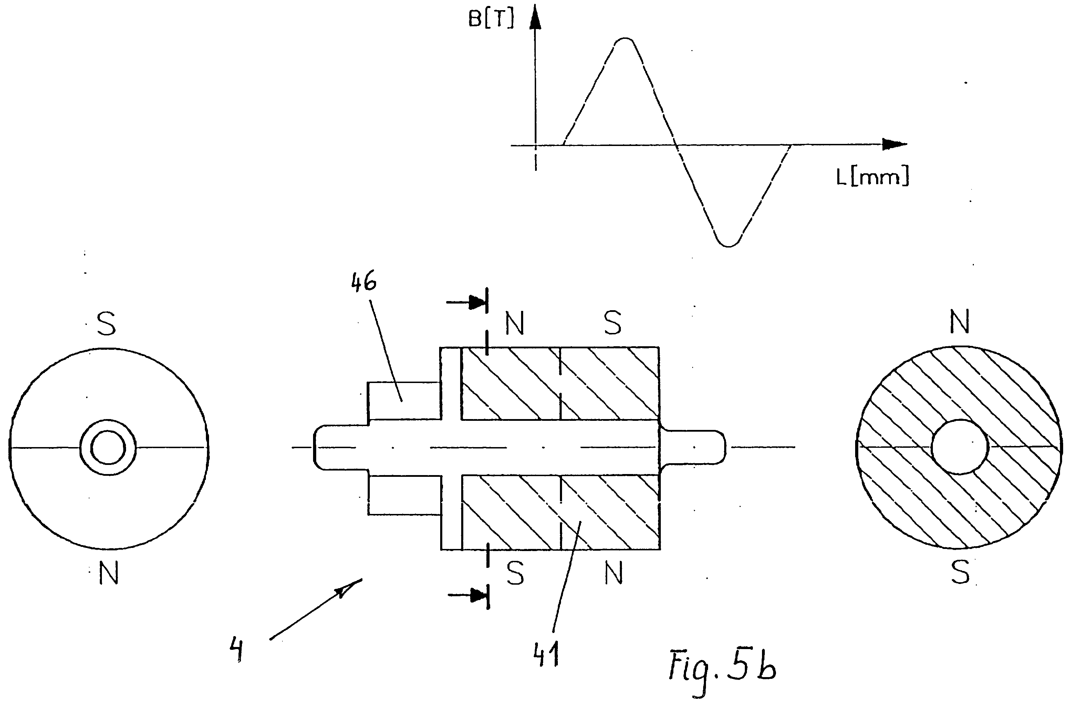

Der Rotor 4 besitzt einen Permanentmagneten 41 aus kunststoffgebundenem Magnetmaterial. Jeweils zwei Pole sind um 180° zueinander winkelversetzt und koaxial beabstandet angeordnet, wie dies in Figur 5b zu erkennen ist. Diese Anordnung gewährleistet, daß jedem Statorblech 20 ein Polpaar des Rotors 4 zugeordnet ist. Damit treten keine Axialkräfte mehr auf und ein Springen des Rotors ist vermieden.

Der Permanentmagnet 41 ist auf einer Rotorwelle 42 (vgl. Figur 3) angebracht, die weiterhin ein Antriebsritzel 46 trägt. Die Rotorwelle 42 geht an beiden Enden einstückig in Lagerzapfen 43, 44 über, die in korrespondierend geformte Zapfenaufnahmen 65, 75 eingesetzt sind. Damit ist der Rotor 4 zwischen dem Gehäuseunterteil 60 und dem Deckel 70 in axialer Richtung fixiert, jedoch drehbar gelagert.

Die Drehbewegung des Rotors 4 wird über das Reduziergetriebe 8 auf eine Abtriebswelle 95 übertragen. Die Abtriebswelle 95 stellt beispielsweise die Zeigerwelle eines Tachometers dar. Das Reduziergetriebe 8 besitzt ein Untersetzungsverhältnis von 60 : 1, so daß die gewünschte Auflösung innerhalb eines vorgesehenen Schwenkbereichs des Zeigers (beispielsweise 300°) erreicht wird. Zur Realisierung des Untersetzungsverhältnisses sind zwei Übertragungsräder 80, 85 vorgesehen, die zwischen dem Antriebsritzel 46 des Rotors 4 und einem die Abtriebswelle 95 tragenden Abtriebsrads 90 eingeschaltet sind. Das Übertragungsrad 80 besitzt eine Verzahnung 81, die mit dem Antriebsritzel 46 kämmt, sowie eine weitere Verzahnung 82, die mit dem nächsten Übertragungsrad 85 in Eingriff ist (Figur 3). Zu diesem Zweck besitzt das Übertragungsrad 85 eine erste Verzahnung 86 sowie eine weitere Verzahnung 87, welche mit einer Verzahnung 91 des Abtriebsrads 90 im Eingriff ist.

Zur Realisierung einer möglichst geringen Bauhöhe des Schrittmotors ist die Anordnung der Übertragungsräder 80, 81 und des Abtriebsrads 90 so gewählt, daß der Freiraum im Gehäuseunterteil, der zwischen den beiden Statoren 20 zur Verfügung steht, optimal genutzt wird. Die Statorbleche 20 sind deshalb jeweils mit dem Freischnitt 28 versehen, in den einerseits das Übertragungsrad 80 mit seinem die Verzahnung 82 tragenden Axialabschnitt hineinragen kann. Andererseits kann von oben ein am Deckel 70 angeordneter Stützzapfen 74 hindurchgeführt werden, der in koaxialer Ausrichtung auf das Übertragungsrad 80 dieses stirnseitig sichert.

Zur gegenüberliegenden Seite hin ist das Übertragungsrad 80 durch einen schulterartigen Ansatz an einem Lagerzapfen 66 gehalten, welcher am Gehäuseunterteil 60 angeformt ist. Der Lagerzapfen 66 ist exakt auf eine das Übertragungsrad 80 durchsetzende Lagerbohrung 83 abgestimmt, so daß keine weiteren Lagerelemente erforderlich sind und eine einfache Montage durch Aufstecken des Übertragungsrads 80 auf den Lagerzapfen 66 ermöglicht wird.

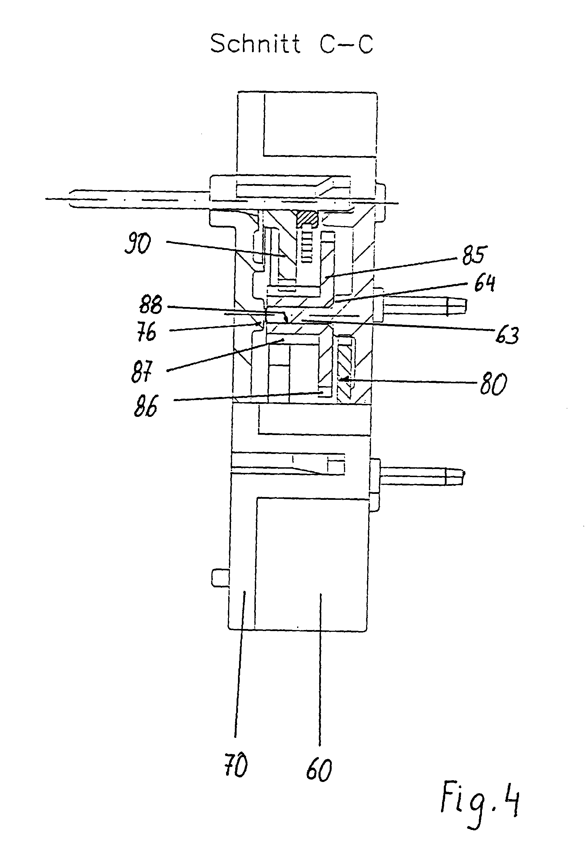

In ähnlicher Weise ist das Übertragungsrad 85 (vgl. Figur 4) gelagert. Es besitzt eine Lagerbohrung 88, die exakt auf einen Lagerzapfen 63 abgestimmt ist. Der Lagerzapfen 63 ist am Gehäuseunterteil 60 angeformt und trägt eine Schulter 64, die als axialer Anschlag für das Übertragungsrad 85 zum Gehäuseunterteil 60 hin darstellt. Deckelseitig ist wiederum ein Stützzapfen 76 vorgesehen, der als axiale Sicherung dient.

Das Abtriebsrad 90 ist im Gehäuseunterteil 60 über die Abtriebswelle 95 gelagert, die in eine Zapfenaufnahme 68 des Gehäuseunterteils 60 eingreift. Weiterhin besitzt das Abtriebsrad 90 eine angeformte Schulter 92, die auf die Innenseite des Deckels gerichtet ist. Gegenüberliegend befindet sich im Deckel 70 eine Durchführung 72 für die Abtriebswelle 95. Die Durchführung 72 ist zum Inneren des Gehäuses 6 hin konisch erweitert ausgeführt, um bei der Montage das Hindurchführen der Abtriebswelle 95 zu erleichtern.

Aus dem Vorstehenden ergibt sich, daß der Schrittmotor durch einfaches Ineinanderstecken der Bauteile montiert werden kann. Es sind hierbei keine besonderen Positionierhilfen erforderlich, da diese bereits am Gehäuseunterteil 60, beispielsweise in Form der Lagerzapfen 63, 66 oder der Zapfenaufnahmen 65, 68, angeformt sind. Zur Fixierung der eingesetzten Bauteile ist es lediglich erforderlich, den Deckel 70 auf das Gehäuseunterteil 60 aufzusetzen und zu verrasten. Durch die in Form der Stützzapfen 74, 76 und Zapfenaufnahme 75 realisierten Positionier- und Fixierelemente ist der Schrittmotor nach dem Zusammenfügen gebrauchsfertig. Zum Verrasten des Deckels 70 sind am Gehäuseunterteil 60 vier Rastnasen 62 angeformt. Weiterhin besitzt das Gehäuseunterteil 60 zwei Befestigungsaugen 61, mit denen der Schrittmotor am Einbauort befestigt werden kann.

Zur Vermeidung von Anzeigefehlern, die durch das im Reduziergetriebe 8 vorhandene Zahnspiel hervorgerufen werden, ist ein Zahnspielausgleich vorgesehen. Dieser ist durch eine Spiralfeder 98 realisiert, die über ein Fixierelement 97 einerseits an der Abtriebswelle 95 und andererseits an einer am Gehäuseunterteil 60 angeformten Halterung 69 vorgespannt ist.

Alternativ (oder auch zusätzlich) kann eine Bremsfeder 99 vorgesehen sein, wie sie in den Figuren 5 und 5a gezeigt ist.

Die Bremsfeder 99 besteht im wesentlichen aus einem elastisch deformierbaren Streifen, beispielsweise aus einem Federstahlstreifen, der auf der Schulter 92 des Abtriebsrads 90 aufliegt und von einem am Deckel 70 angeformten Widerlager 73 in Richtung auf das Gehäuseunterteil 60 gedrückt wird. Hierdurch wird infolge von Reibung zwischen der Schulter 92 und der Bremsfeder 99 die gewünschte Bremswirkung erzielt.

Die in Figur 5a dargestellte Ausführungsvariante besitzt die Bremsfeder 99 anstelle des Zahnspielausgleichs bzw. Spiralfeder 98, wohingegen die Ausführungsform gemäß Figur 5 sowohl Spiralfeder 98 als auch Bremsfeder 99 aufweist.

Von den genannten Unterschieden abgesehen, sind sämtliche Ausführungsvarianten baugleich ausgeführt. Je nach Genauigkeitsanforderung können unter Beibehaltung des identischen Aufbaus unterschiedliche Konzeptionen zur Erhöhung der Anzeigegenauigkeit bzw. -qualität realisiert sein.

### BEZUGSZEICHENLISTE

- 2: Stator
- 4: Rotor
- 6: Gehäuse
- 8: Reduziergetriebe

- 20: Statorblech
- 21: Steg
- 22: Schenkel
- 23: Ausnehmung
- 24: Befestigungsloch
- 25: Schenkel
- 26: Ausnehmung
- 27: Befestigungsloch
- 28: Freischnitt
- 29: Befestigungsloch

- 30: Spule
- 31: Deckscheibe
- 32: Anschlußstift
- 33: Deckscheibe
- 34: Anschlußstift
- 35: Wicklung

- 41: Permanentmagnet
- 42: Rotorwelle
- 43: Lagerzapfen
- 44: Lagerzapfen
- 46: Antriebsritzel

- 60: Gehäuseunterteil
- 61: Befestigungsauge
- 62: Rastnase
- 63: Lagerzapfen
- 64: Schulter
- 65: Zapfenaufnahme
- 66: Lagerzapfen
- 68: Zapfenaufnahme
- 69: Halterung

- 70: Deckel
- 72: Durchführung
- 73: Widerlager
- 74: Stützzapfen
- 75: Zapfenaufnahme
- 76: Stützzapfen

- 80: Übertragungsrad
- 81: Verzahnung
- 82: Verzahnung
- 83: Lagerbohrung

- 85: Übertragungsrad
- 86: Verzahnung
- 87: Verzahnung
- 88: Lagerbohrung

- 90: Abtriebsrad
- 91: Verzahnung
- 92: Schulter

- 95: Abtriebswelle

- 97: Fixierelement
- 98: Spiralfeder
- 99: Bremsfeder

## Patentansprüche

1. Schrittmotor mit einem Rotor (4) und zwei übereinander und zueinander winkelversetzt angeordneten Statoren (2), die aus Spulen (30) und Statorblechen (20) bestehen, wobei die Statorbleche (20) jeweils eine ebene U-förmige Gestalt mit zwei im wesentlichen parallel verlaufenden Schenkeln (22, 25) besitzen und wenigstens ein Schenkel (22, 25) zur Bildung eines Polpaares endseitig eine kreissegmentförmige Ausnehmung (23, 26) aufweist derart, daß der zwischen zwei Ausnehmungen (23,26) hindurchgeführte Rotor (4) in Draufsicht längs zweier gegenüberliegender Umfangsabschnitte konturangepaßt, jedoch berührungsfrei umfaßt ist,
dadurch gekennzeichnet, daß die kreissegmentförmigen Ausnehmungen (23, 26) an den sich gegenüberliegenden Schenkelenden eines einzigen Statorblechs (20) angeordnet sind.

2. Schrittmotor nach Anspruch 1, dadurch gekennzeichnet, daß die Statorbleche (20) um 90° zueinander winkelversetzt angeordnet sind.

3. Schrittmotor nach Anspruch 1 oder 2, dadurch gekennzeichnet, daß im Axialschnitt der Abstand zwischen den beiden Statorblechen (20) geringer ist als deren Dicke.

4. Schrittmotor nach einem der vorhergehenden Ansprüche, dadurch gekennzeichnet, daß die Statorbleche (20) einstückig ausgeführt sind.

5. Schrittmotor nach einem der vorstehenden Ansprüche, dadurch gekennzeichnet, daß beide Statorbleche (20) deckungsgleich ausgebildet und in spiegelbildlicher Anordnung eingesetzt sind.

6. Schrittmotor nach einem der vorhergehenden Ansprüche, dadurch gekennzeichnet, daß die Spulen (30) jeweils über einen der beiden Schenkel (22, 25) geschoben und dort verrastet sind.

7. Schrittmotor nach Anspruch 6, dadurch gekennzeichnet, daß beide Spulen (30) identisch ausgebildet sind.

8. Schrittmotor nach einem der vorhergehenden Ansprüche, dadurch gekennzeichnet, daß der Rotor (4) zwei Polpaare aufweist, die zueinander um 180° winkelversetzt und koaxial beabstandet angeordnet sind, wobei der koaxiale Abstand dem Abstand der beiden Statorbleche (20) entspricht.

9. Schrittmotor nach einem der vorstehenden Ansprüche, gekennzeichnet durch ein Gehäuse (6), bestehend aus einem Gehäuseunterteil (60) zur positionierenden Aufnahme der Statoren (2), des Rotors (4) sowie gegebenenfalls eines Reduziergetriebes (8) und einem Deckel (70).

10. Schrittmotor nach Anspruch 8, dadurch gekennzeichnet, daß der Deckel (70) mit dem Gehäuseunterteil (60) verrastet ist und hierdurch sämtliche Bauteile fixiert sind.

## Claims

1. Stepping motor having a rotor (4) and having two stators (2) which are arranged one above the other and with an angular offset with respect to one another and are composed of coils (30) and stator plates (20), the stator plates (20) each having a smooth U-shaped form with two limbs (22, 25) which run essentially parallel, and at least one limb (22, 25) having a recesses (23, 26) in the form of a segment of a circle at the end in order to form a pole pair, in such a manner that the rotor (4) which is passed through between two recesses (23, 26) has matched contours in plan view along two opposite circumferential sections, but is surrounded without being touched, characterized in that the recess (23, 26) in the form of the segments of circles are arranged at the mutually opposite limb ends of a single stator plate (20).

2. Stepping motor according to Claim 1, characterized in that the stator plates (20) are arranged with an angular offset of 90° with respect to one another.

3. Stepping motor according to Claim 1 or 2, characterized in that, in axial section, the distance between the two stator plates (20) is less than their thickness.

4. Stepping motor according to one of the preceding claims, characterized in that the stator plates (20) are formed integrally.

5. Stepping motor according to one of the above claims, characterized in that both stator plates (20) are designed to be superimposed and are inserted in a mirror-image arrangement.

6. Stepping motor according to one of the preceding claims, characterized in that the coils (30) are each pushed over one of the two limbs (22, 25), and are latched there.

7. Stepping motor according to Claim 6, characterized in that the two coils (30) are of identical design.

8. Stepping motor according to one of the preceding claims, characterized in that the rotor (4) has two pole pairs which are arranged with an angular offset of 180° with respect to one another and with a coaxial distance between them, the coaxial distance corresponding to the distance between the two stator plates (20).

9. Stepping motor according to one of the above claims, characterized by a housing (6) comprising a cover (70) and a housing lower part (60) for holding the stators (2), the rotor (4) and, possibly, a reduction drive (8) in position.

10. Stepping motor according to Claim 8, characterized in that the cover (70) is latched to the housing lower part (60), and all the components are fixed in this way.

## Revendications

1. Moteur pas à pas comprenant un rotor (4) et deux stators (2) agencés en superposition, décalés angulairement l'un par rapport à l'autre et constitués par des enroulements (30) et par des tôles statoriques (20), les tôles statoriques (20) possédant respectivement une configuration plane en U munie de deux branches (22, 25) s'étendant pour l'essentiel parallèlement, et au moins une branche (22, 25) présentant un évidement (23, 26) en forme de secteur circulaire, côté extrémité, en vue de former une paire de pôles, de telle sorte que le rotor (4) s'étendant d'un trait entre deux évidements (23, 26) soit ceinturé, observé en plan, le long de deux segments périphériques opposés, avec adaptation de forme mais toutefois sans aucun contact, caractérisé par le fait que les évidements (23, 26) en forme de secteurs circulaires sont disposés aux extrémités des branches d'une unique tôle statorique (20) qui sont mutuellement opposées.

2. Moteur pas à pas selon la revendication 1, caractérisé par le fait que les tôles statoriques (20) sont agencées avec décalage angulaire mutuel de 90°.

3. Moteur pas à pas selon la revendication 1 ou 2, caractérisé par le fait que, en coupe axiale, l'espacement entre les deux tôles statoriques (20) est plus faible que l'épaisseur desdites tôles.

4. Moteur pas à pas selon l'une des revendications précédentes, caractérisé par le fait que les tôles statoriques (20) sont de réalisation monobloc.

5. Moteur pas à pas selon l'une des revendications précédentes, caractérisé par le fait que les deux tôles statoriques (20) sont de réalisation coïncidente et sont intégrées en une disposition spéculaire.

6. Moteur pas à pas selon l'une des revendications précédentes, caractérisé par le fait que les enroulements (30) sont respectivement enfilés sur l'une des deux branches (22, 25), sur laquelle ils sont encliquetés.

7. Moteur pas à pas selon la revendication 6, caractérisé par le fait que les deux enroulements (30) sont de réalisation identique.

8. Moteur pas à pas selon l'une des revendications précédentes, caractérisé par le fait que le rotor (4) comporte deux paires de pôles agencées avec décalage angulaire mutuel de 180° et avec espacement coaxial, l'espacement coaxial correspondant à l'espacement des deux tôles statoriques (20).

9. Moteur pas à pas selon l'une des revendications précédentes, caractérisé par un carter (6) composé d'une partie inférieure (60) pour recevoir, avec effet de positionnement, les stators (2), le rotor (4) et éventuellement un engrenage réducteur (8) ; ainsi que d'un couvercle (70).

10. Moteur pas à pas selon la revendication 8, caractérisé par le fait que le couvercle (70) est encliqueté sur la partie inférieure (60) du carter, et toutes les pièces structurelles sont ainsi consignées à demeure.
